# EUROPÄISCHE PATENTANMELDUNG

(11) **EP 2 226 701 A1**
(43) Veröffentlichungstag der Anmeldung: **08.09.2010**
(21) Anmeldenummer: 10154405.4
(22) Anmeldetag: 23.02.2010
(51) Int. Cl.: G06F 1/20

(54) **Klimasystem**

(30) Priorität: 02.03.2009 DE 102009011006
(71) Anmelder: Rittal Gmbh&Co. Kg, 35745 Herborn (DE)
(72) Erfinder: Nicolai, Michael, 35466, Allertshausen (DE); Nonn, Helmut, 57629, Malberg (DE); Siegel, Tim, Houston, TX, 77069 (US)
(74) Vertreter: Fleck, Hermann-Josef

(57) **Zusammenfassung**

Die Erfindung betrifft ein Klimasystem für eine Datenverarbeitungsanlage, die mindestens eine Reihe von Server-Schaltschränken aufweist, wobei die Reihe von Server-Schaltschränken einen Kaltgang begrenzt, wobei von wenigstens einem Klimagerät Warmluft angesaugt, gekühlt und als Kaltluft wieder ausgeblasen wird.

Erfindungsgemäß ist dabei vorgesehen, dass das Klimagerät in die Reihe der Schaltschränke integriert ist, wobei die Abmessungen des Klimagerätes und die Abmessungen der Server-Schaltschränke im Wesentlichen gleich sind oder, bei gleicher Höhe und Tiefe, die Breite des Klimagerätes einem ganzzahligen Vielfachen der Breite eines Server-Schaltschranks entspricht.

Mit dem vorgestellten Klimasystem kann ein effektives Kühlkonzept für temperatursensitive Datenverarbeitungsanlagen bereitgestellt werden, welches die direkte Umgebung nur wenig mit Warmluft beeinflusst. Durch den modularen Aufbau kann die Kühlleistung skaliert werden, wobei auch eine nachträgliche Erweiterung ermöglicht wird.

## Beschreibung

Die Erfindung betrifft ein Klimasystem für eine Datenverarbeitungsanlage, die mindestens eine Reihe von Server-Schaltschränken aufweist, wobei die Reihe von Server-Schaltschränken einen Kaltgang begrenzt, wobei von wenigstens einem Klimagerät Warmluft angesaugt, gekühlt und als Kaltluft wieder ausgeblasen wird.

Datenverarbeitungsanlagen bestehen in der Regel aus einer Vielzahl von Server-Schaltschränken, in die einzelne Elektronik-Einschübe (so genannte Racks) mit eigenen Lüftern mit Kaltluftansaugungen und Warmluftausgängen zur Kühlung eingebaut sind.

Die Server-Schaltschränke sind in mehreren Reihen angeordnet und dabei derart ausgerichtet, dass sich die Kaltluftansaugungen bzw. die Warmluftausgänge der einzelnen Server-Schaltschränke jeweils gegenüber befinden und zwischen den Server-Schaltschränken abwechselnd entsprechende Kaltgänge und Warmgänge ausgebildet sind. Bei einer zweireihigen Anordnung von Server-Schaltschränken ist in der Regel zwischen den beiden Server-Schaltschrankreihen ein Kaltgang ausgebildet. Die Warmluftausgänge der Server-Schaltschränke befinden sich dabei an der Außenseite dieser Anordnung und blasen die Warmluft in den umgebenden Raum ab.

Zur Klimatisierung bzw. insbesondere zur Kühlung dieser Datenverarbeitungsanlagen sind unterschiedliche Konzepte aus dem Stand der Technik bekannt.

So kann beispielsweise vorgesehen sein, dass die von den Server-Schaltschränken ausgeblasenen Warmluft zentral von einem Klimasystem angesaugt, gekühlt und die Kaltluft in den Kaltgang eingeblasen wird. Um die Effizienz der Kühlung zu erhöhen, ist in der Regel der Kaltgang gegenüber den Warmgängen bzw. dem umgebenden Raum seitlich und von oben abgeschottet. In den Schriften WO 03/083631 und US 6,859,366 B2 sind beispielsweise derartige Anordnungen beschrieben.

Hinsichtlich einer besonders effektiven Klimatisierung derartiger Anordnungen haben sich so genannte Inline-Klimageräte bewährt, die zwischen den Server-Schaltschränken in bestimmten Abständen, abhängig von der abzuführenden Verlustleistung der Datenverarbeitungsanlage, angeordnet sind. Diese Klimageräte weisen Lüfter auf, die die Warmluft aus den Warmgängen oder aus der umgebenden Luft über Warmluftansaugungen ansaugen, mittels eines oder mehrerer mit Wasser durchströmten Wärmetauscher kühlen und über Kaltlufteinblasungen in die abgeschotteten Kaltgänge einblasen.

Im Produktkatalog "RITTAL Handbuch 32 / IT-Solutions", Seite 726ff. sowie in der Informationsbroschüre "RITTAL IT-Cooling Solutions", 03/08 sind beispielsweise entsprechende Klimageräte unter dem Namen "LCP Inline" aufgeführt.

LCP steht für Liquid Cooling Package und beschreibt Klimageräte, welche innerhalb der Datenverarbeitungsanlagen zwischen Server-Schaltschränken platziert werden können und Wärmetauscher mit einer Wasserkühlung aufweisen.

Nachteilig ist bei den derzeit auf dem Markt befindlichen Klimasystemen, dass diese jeweils eine Unterbrechung der Server-Schaltschrank-Anordnung darstellen, da die Bauform von der der Server-Schaltschränke deutlich abweicht.

Es ist daher Aufgabe der Erfindung ein Klimasystem bereitzustellen, welches hinsichtlich seines Aufbaus voll in eine Datenverarbeitungsanlage integrierbar ist.

Die Aufgabe der Erfindung wird dadurch gelöst, dass das Klimagerät in die Reihe der Schaltschränke integriert ist, wobei die Abmessungen des Klimagerätes und die Abmessungen der Server-Schaltschränke im Wesentlichen gleich sind oder, bei gleicher Höhe und Tiefe, die Breite des Klimagerätes einem ganzzahligen Vielfachen der Breite eines Server-Schaltschranks entspricht.

Mit diesem Klimasystem kann gegenüber den zentral installierten Klimasystemen erreicht werden, dass die Warmluft direkt am Entstehungsort abgesaugt und dem Kaltgang als Kaltluft wieder zugeführt werden kann. Luftseitige Druckverluste und damit die Leistungsaufnahme der Lüfter werden auf ein Minimum gebracht, da nur kurze Strömungslängen berücksichtigt werden müssen. Weiterhin wird die Umgebung der Datenverarbeitungsanlage nur noch geringfügig durch Warmluft beeinflusst, womit ein effektives Kühlkonzept für temperatursensitive Datenverarbeitungsanlagen bereitgestellt wird. Vorteilhaft ist dabei insbesondere, dass das Klimagerät oder die Klimageräte aufgrund der gleichen Abmessungen wie die Server-Schaltschränke direkt in die Reihen der Server-Schaltschränke integriert werden können, ohne dass die Rasteraufteilung für die Server-Schaltschränke unterbrochen sind.

Besonders vorteilhaft ist dabei, dass das Klimagerät aus mindestens einem Grundmodul und ggf. zusätzlichen Erweiterungsmodulen aufgebaut ist, wobei die Anzahl der Erweiterungsmodule abhängig von der benötigten Kühlleistung für die Datenverarbeitungsanlage angepasst ist.

In bevorzugter Ausführung sind die Abmessungen des Grundmoduls und der Erweiterungsmodule des Klimagerätes im Wesentlichen gleich, wobei die Abmessungen des Grundmoduls und der Erweiterungsmodule des Klimagerätes denen eines Server-Schaltschranks entsprechen. Dies betrifft insbesondere die Bautiefe und Baubreite der Grundmodule und der Erweiterungsmodule. Durch diesen modularen Aufbau kann die Kühlleistung beliebig skaliert werden, wobei auch eine nachträgliche Erweiterung ermöglicht wird. Zudem kann mit diesem Konzept auch eine Redundanz beim Klimasystem erreicht werden, wenn beispielsweise mindestens zwei Grundmodule in einer Datenverarbeitungsanlage installiert sind.

Ein variabler Einsatz derartiger Klimageräte wird ermöglicht, wenn einerseits die Kaltluft mittels mindestens einer Kaltluftausblasung senkrecht nach unten über Doppelböden oder waagrecht über perforierte Frontelemente des Klimagerätes in den Kaltgang einleitbar ist.

Bei waagrechter Kaltluftausblasung in den Kaltgang sind im Grundmodul sowie in den Erweiterungsmodulen vorzugsweise luftausgangsseitig Einrichtungen zur Abbremsung der Luftströmung vorgesehen. Dies kann beispielsweise mit einem Überdruckplenum realisiert werden, welches direkt in Strömungsrichtung zwischen der Ausblasöffnung des Lüfters und den perforierten Frontelementen des Klimagerätes angeordnet ist. Damit kann erreicht werden, dass bei direkter Kaltgangeinblasung die Luftströmung auf ein bestimmtes Maß reduziert und insbesondere auch homogenisiert ist.

Hinsichtlich einer Variabilität bei der Warmluftansaugung kann vorgesehen sein, dass die Warmluft mittels mindestens einer Warmluftansaugung über Öffnungen an der Rückseite, beispielsweise über eine perforierte Rückwandtür, und/ oder an der Oberseite des Klimagerätes ansaugbar ist. Bei einer horizontalen Absaugung an der Rückseite kann beispielsweise die Warmluft auch direkt aus einer Warmgangabschottung angesaugt werden, womit sich eine besonders effektive Kühlung der Datenverarbeitungsanlage realisieren lässt.

Bei einer bevorzugten Ausführungsform des Klimasystems ist vorgesehen, dass alle übergeordneten Komponenten des Klimagerätes im Grundmodul installiert sind. So ist vorgesehen, dass das Grundmodul des Klimagerätes mindestens einen Wärmetauscher aufweist, der eine Anbindung zu wasserführenden Systemen besitzt, sowie eine Steuerung von Lüftern und Wasserkreislauf aufweist.

Das Erweiterungsmodul des Klimagerätes weist mindestens einen Wärmetauscher und mindestens einen Lüfter auf, wobei die Lüfter sowie der Wasserkreislauf für die Wärmetauscher des Erweiterungsmoduls von der Steuerung des Grundmoduls aus steuerbar sind und das Grundmodul dafür entsprechende Schnittstellen zur Anbindung der Erweiterungsmodule aufweist. Das Erweiterungsmodul übernimmt die Funktion, die Kühlleistung des Klimagerätes zu erhöhen und wird vom Grundmodul entsprechend angesteuert. Zudem kann es auch mit Kühlwasser versorgt werden. Dies bringt eine Kostenersparnis bei der Installation derartiger Klimasysteme mit sich. Eine nachträgliche Anreihung zusätzlicher Erweiterungsmodule ist mit diesem Konzept jederzeit möglich.

Ist der Wärmetauscher im Grundmodul oder in den Erweiterungsmodulen des Klimagerätes in der Seitenansicht schräg stehend eingebaut, steht eine größere Wärmetauscherfläche für die Kühlung zur Verfügung. Dabei kann vorgesehen sein, dass sich der Wärmetauscher in der Seitenansicht im Wesentlichen nahezu über die komplette Diagonale des Innenraums des Klimagerätes erstreckt.

In bevorzugter Ausführungsform weisen die Wärmetauscher des Grundmoduls und der Erweiterungsmodule des Klimagerätes zuluftseitig einen Filter auf, mit dem die angesaugte Luft hinsichtlich Staubpartikel in der Luft gefiltert werden kann. Damit kann die Staubbelastung für die Datenverarbeitungsanlage deutlich reduziert werden. Dabei kann der Filter als Kassettenfilter ausgeführt sein, was einen schnellen Filterwechsel begünstigt.

Weist das Grundmodul des Klimagerätes einen Dampfbefeuchter auf, der mittels der Steuerung ansteuerbar ist, kann damit auch eine Beeinflussung der relativen Luftfeuchte realisiert werden.

Sind die Lüfter als EC-Ventilatoren (electronically commutated) ausgebildet, kommen hoch effiziente drehzahlsteuerbare Lüfter zum Einsatz, die gegenüber klassischen Asynchronmotoren Vorteile hinsichtlich einem höheren Wirkungsgrad über weite Drehzahlbereiche und hinsichtlich einem universellen Einsatz mit sich bringen. So sind beispielsweise keine unterschiedlichen Varianten erforderlich, falls die Lüfter mit 50 Hz oder mit 60 Hz betrieben werden müssen. Im vorliegenden Einsatzgebiet sind diese EC-Ventilatoren jeweils mit einem Laufradgehäuse zur einfachen Änderung der Ausblasrichtung ausgerüstet.

Ist der Kaltgang gegenüber der Umgebung abgeschottet, kann die Effizienz der Kühlung der Datenverarbeitungsanlage deutlich gesteigert werden. Damit ergibt sich zudem eine bessere Kontrolle der Strömungsverhältnisse.

Die Erfindung wird im Folgenden anhand eines in den Figuren dargestellten Ausführungsbeispiels näher erläutert. Es zeigt:
- Fig. 1: eine Datenverarbeitungsanlage mit integriertem Klimagerät in Draufsicht,
- Fig. 2: eine weitere Datenverarbeitungsanlage in der Frontansicht,
- Fig. 3: die Datenverarbeitungsanlage aus Fig. 2 in der Seitenansicht,
- Fig. 4: eine andere Datenverarbeitungsanlage mit zwei integrierten als Grundmodul ausgeführten Klimageräten in Draufsicht,
- Fig. 5: eine weitere Datenverarbeitungsanlage mit zwei integrierten als Grundmodul ausgeführten Klimageräten mit je zwei zusätzlichen Erweiterungsmodulen in Draufsicht und
- Fig. 6: das Klimagerät in einer schematischen Schnittdarstellung.

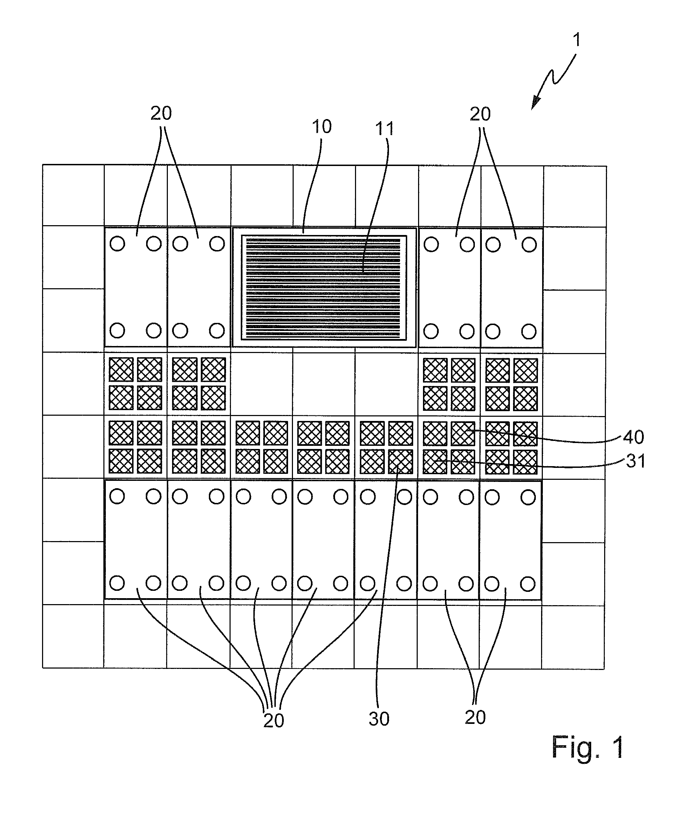

Fig. 1 zeigt eine Datenverarbeitungsanlage 1 mit einem integrierten Klimagerät 10 in der Draufsicht. Die Datenverarbeitungsanlage 1 ist im gezeigten Beispiel als zweireihige Anordnung von Server-Schaltschränken 20 ausgebildet, die einen Kaltgang 40 einschließen. Der Kaltgang 40 kann dabei hinsichtlich einer Effizienzsteigerung der Kühlung gegenüber dem umgebenden Raum abgeschottet sein. Dazu sind Türund Deckenabschottungen vorgesehen, die in dieser Figur aber nicht dargestellt sind. Die Server-Schaltschränke 20 und das Klimagerät 10 stehen dabei auf einem Boden 30, der als Doppelboden ausgeführt ist und über den Kaltluft über Lüftungsgitter 31 im Boden 30 in den Kaltgang 40 einleitbar ist. Das Klimagerät 10 ist dabei in eine Reihe der Server-Schaltschränke 20 integriert und entspricht im gezeigten Beispiel exakt der Grundfläche von drei Server-Schaltschränken 20. In dieser Ansicht sind an der Oberseite des Klimagerätes 10 Öffnungen gezeigt, die als Warmluftansaugung 11 dienen.

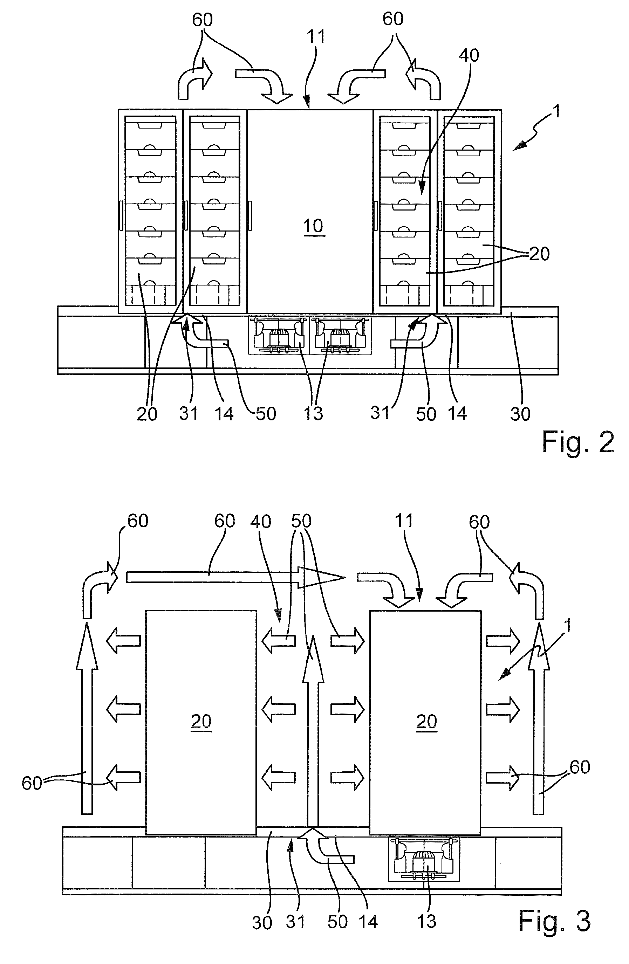

Fig. 2 zeigt eine weitere Datenverarbeitungsanlage 1 in der Frontansicht. Das Klimagerät 10 ist im gezeigten Beispiel ebenfalls in eine Reihe von Server-Schaltschränken 20 integriert und entspricht in seiner Abmessung zwei Server-Schaltschränken 20.

In dieser Figur sind zusätzlich eine Kaltluft- und eine Warmluftströmung 50, 60 gezeigt. Die von den Server-Schaltschränken 20 aufsteigende Warmluft wird dabei vom Klimagerät 10 über die Warmluftansaugung im Deckenbereich des Klimagerätes 10 angesaugt und über eine Kaltluftausblasung 14 mittels Lüfter 13 durch den als Doppelboden ausgeführten Boden 30 geleitet und über Lüftungsgitter 31 in den Kaltgang 40 eingeleitet.

In Fig. 3 ist die Datenverarbeitungsanlage 1 aus Fig. 2 von der Seite gezeigt. Gezeigt sind die Kaltluft- und die Warmluftströmungen 50, 60. Die Server-Schaltschränke 20 sind in zwei Reihen angeordnet und dabei derart ausgerichtet, dass sich die Kaltluftansaugungen bzw. die Warmluftausgänge der einzelnen Server-Schaltschränke 20 jeweils gegenüber befinden. Bei dieser zweireihigen Anordnung von Server-Schaltschränken 20 ist zwischen den beiden Server-Schaltschrankreihen der Kaltgang 40 ausgebildet. Die Warmluftausgänge der Server-Schaltschränke befinden sich dabei an der Außenseite dieser Anordnung und blasen die Warmluft in den umgebenden Raum ab.

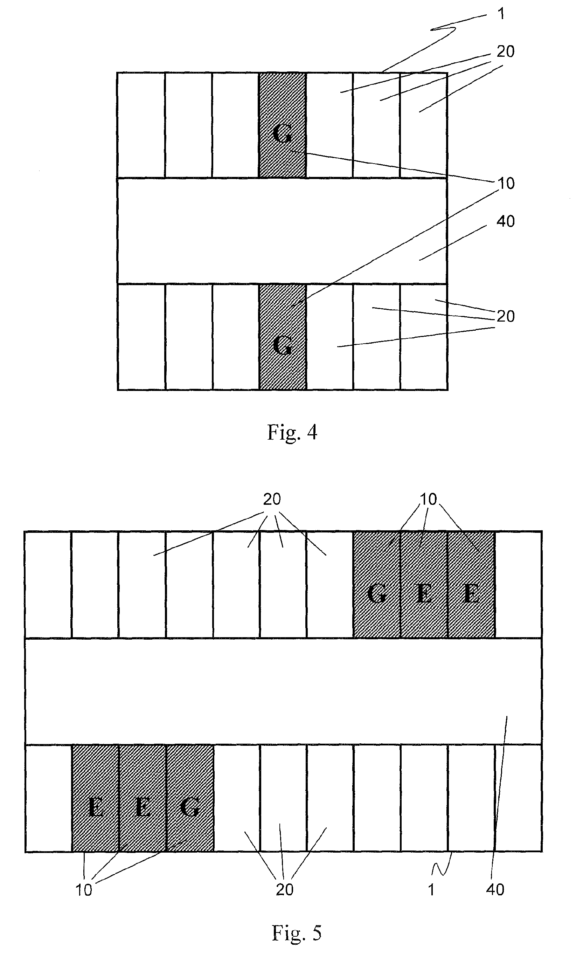

Fig. 4 und Fig. 5 zeigen schematisch in Draufsicht weitere Anordnungen einer Datenverarbeitungsanlage 1 in unterschiedlicher Größe, bei denen die Server-Schaltschränke 20 jeweils zweireihig angeordnet sind, und zwischen den Reihen ein abgeschotteter Kaltgang 40 ausgebildet ist.

In Fig. 4 ist eine Anordnung gezeigt, bei der jeweils ein Grundmodul (gekennzeichnet mit "G") des Klimagerätes 10 in eine Reihe der Server-Schaltschränke 20 integriert ist. In Fig. 5 ist aufgrund der größeren Datenverarbeitungsanlage 1 eine erhöhte Kühlleistung gefordert. In diesem Beispiel sind den Grundmodulen des Klimagerätes 10 jeweils zwei Erweiterungsmodule (gekennzeichnet mit "E") zugeordnet.

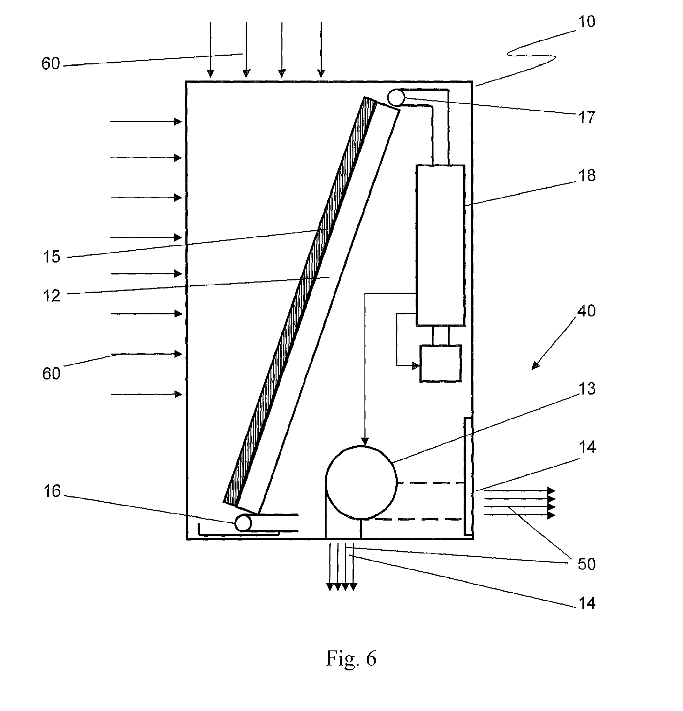

Fig. 6 zeigt schematisch in einer Schnittdarstellung das Klimagerät 10 mit seinen Hauptkomponenten. Dargestellt sind weiterhin die Kaltluft- und Warmluftströmungen 50, 60. Die Warmluft kann sowohl horizontal durch eine perforierte rückseitig angebrachte Tür oder vertikal von oben durch einen Dachblech-Ausbruch erfolgen.

Dabei ist auch die Möglichkeit gegeben, einen Luftkanal oder eine Gehäuseverlängerung montieren zu können.

Die Warmluft, welche mittels Lüfter 13 angesaugt wird, durchströmt zunächst einen im Gehäuse des Klimagerätes 10 schräg stehenden Wärmetauscher 12 und wird dabei abgekühlt. Dem Wärmetauscher 12 ist zuluftseitig ein Filter 15 zugeordnet, welcher als Kassettenfilter ausgelegt sein kann. Der oder die Lüfter 13 sind als EC-Radialventilatoren ausgelegt und können je nach Anwendungsfall die Kaltluft über eine Kaltluftausblasung 14 vertikal nach unten in einen Doppelboden in den Kaltgang 40 oder horizontal über perforierte Frontelemente, beispielsweise über eine perforierte Fronttür, des Klimageräts 10 direkt in den Kaltgang 40 blasen. Dazu können die Lüfter 13 unterschiedlich orientiert im Klimagerät 10 eingebaut sein. In diesem Fall sind luftausgangsseitig Einrichtungen, wie beispielsweise ein Überdruckplenum, zur Abbremsung der Luftströmung vorgesehen.

Die Wärmetauscher 12 sind dabei an einem Kühlwassersystem angeschlossen und weisen entsprechende Verteiler 16 und Sammler 17 auf. Eine Steuerung 18 regelt dabei den Kühlwasserkreislauf sowie die Durchflussleistung der Lüfter 13.

Im Grundmodul des Klimagerätes 10 ist vorgesehen, dass eine Anbindung an einen externen Wasserkreislauf vorgesehen ist. Weiterhin sind im Grundmodul des Klimagerätes 10 Schnittstellen vorgesehen, an die zur Erweiterung der Kühlleistung des Klimagerätes 10 Erweiterungsmodule anschließbar sind. Diese Schnittstellen betreffen insbesondere die Steuerung des Kühlwasserkreislaufs und die Ansteuerung der Lüfter 13 im Erweiterungsmodul, welches selbst keine Steuerung aufweist.

Die Steuerung 18 kann, wie dies in einer Parallel-Anmeldung der Anmelderin beschrieben ist, eine Differenzdruck-Regelung der Lüfterleistung der Lüfter 13 aufweisen. Weiterhin kann auch eine Regelung der relativen Luftfeuchte mittels eines Dampfbefeuchters vorgesehen sein. Zudem können auch zusätzliche Lüfter 13, die beispielsweise im Bereich des Doppelbodens angeordnet sind (siehe Fig. 2 und 3), angesteuert und damit der Luftdurchsatz des Klimasystems geregelt werden.

Mit dem vorgestellten Klimasystem kann ein effektives Kühlkonzept für temperatursensitive Datenverarbeitungsanlagen bereitgestellt werden, welches die direkte Umgebung nur wenig mit Warmluft beeinflusst. Durch den modularen Aufbau kann die Kühlleistung skaliert werden, wobei auch eine nachträgliche Erweiterung ermöglicht wird.

## Patentansprüche

1. Klimasystem für eine Datenverarbeitungsanlage (1), die mindestens eine Reihe von Server-Schaltschränken (20) aufweist, wobei die Reihe von Server-Schaltschränken (20) einen Kaltgang (40) begrenzt, wobei von wenigstens einem Klimagerät (10) Warmluft angesaugt, gekühlt und als Kaltluft wieder ausgeblasen wird,
**dadurch gekennzeichnet,**
**dass** das Klimagerät (10) in die Reihe der Server-Schaltschränke (20) integriert ist, wobei die Abmessungen des Klimagerätes (10) und die Abmessungen der Server-Schaltschränke (20) im Wesentlichen gleich sind oder, bei gleicher Höhe und Tiefe, die Breite des Klimagerätes (10) einem ganzzahligen Vielfachen der Breite eines Server-Schaltschranks (20) entspricht.

2. Vorrichtung nach Anspruch 1,
**dadurch gekennzeichnet,**
**dass** das Klimagerät (10) aus mindestens einem Grundmodul und ggf. weiteren Erweiterungsmodulen aufgebaut ist, wobei die Anzahl der Erweiterungsmodule abhängig von der benötigten Kühlleistung für die Datenverarbeitungsanlage (1) angepasst ist.

3. Vorrichtung nach Anspruch 1 oder 2,
**dadurch gekennzeichnet,**
**dass** die Abmessungen des Grundmoduls und der Erweiterungsmodule des Klimagerätes (10) im Wesentlichen gleich sind.

4. Vorrichtung nach einem der Ansprüche 1 bis 3,
**dadurch gekennzeichnet,**
**dass** die Abmessungen des Grundmoduls und der Erweiterungsmodule des Klimagerätes (10) denen eines Server-Schaltschranks (20) entsprechen.

5. Vorrichtung nach einem der Ansprüche 1 bis 4,
**dadurch gekennzeichnet,**
**dass** die Kaltluft mittels mindestens einer Kaltluftausblasung (14) senkrecht nach unten über Doppelböden oder waagrecht über perforierte Frontelemente des Klimagerätes (10) in den Kaltgang (40) einleitbar ist.

6. Vorrichtung nach Anspruch 5,
**dadurch gekennzeichnet,**
**dass** bei waagrechter Kaltluftausblasung (14) in den Kaltgang (40) im Grundmodul sowie in den Erweiterungsmodulen luftausgangsseitig Einrichtungen zur Abbremsung der Luftströmung vorgesehen sind.

7. Vorrichtung nach einem der Ansprüche 1 bis 6,
**dadurch gekennzeichnet,**
**dass** die Warmluft mittels mindestens einer Warmluftansaugung (11) über Öffnungen an der Rückseite und/ oder an der Oberseite des Klimagerätes (10) ansaugbar ist.

8. Vorrichtung nach einem der Ansprüche 1 bis 7,
**dadurch gekennzeichnet,**
**dass** das Grundmodul des Klimagerätes (10) mindestens einen Wärmetauscher (12) aufweist, der eine Anbindung zu wasserführenden Systemen besitzt, sowie eine Steuerung (18) von Lüftern (13) und Wasserkreislauf aufweist.

9. Vorrichtung nach einem der Ansprüche 1 bis 8,
**dadurch gekennzeichnet,**
**dass** das Erweiterungsmodul des Klimagerätes (10) mindestens einen Wärmetauscher (12) und mindestens einen Lüfter (13) aufweist, wobei die Lüfter (13) sowie der Wasserkreislauf für die Wärmetauscher (12) des Erweiterungsmoduls von der Steuerung (18) des Grundmoduls aus steuerbar sind und das Grundmodul dafür entsprechende Schnittstellen zur Anbindung der Erweiterungsmodule aufweist.

10. Vorrichtung nach Anspruch 8 oder 9,
**dadurch gekennzeichnet,**
**dass** der Wärmetauscher (12) im Grundmodul oder in den Erweiterungsmodulen des Klimagerätes (10) in der Seitenansicht schräg stehend eingebaut ist.

11. Vorrichtung nach einem der Ansprüche 1 bis 10,
**dadurch gekennzeichnet,**
**dass** die Wärmetauscher (12) des Grundmoduls und der Erweiterungsmodule des Klimagerätes (10) zuluftseitig einen Filter (15) aufweisen.

12. Vorrichtung nach Anspruch 11,
**dadurch gekennzeichnet,**
**dass** der Filter (15) als Kassettenfilter ausgeführt ist.

13. Vorrichtung nach einem der Ansprüche 1 bis 12,
**dadurch gekennzeichnet,**
**dass** das Grundmodul des Klimagerätes (10) einen Dampfbefeuchter aufweist, der mittels der Steuerung (18) ansteuerbar ist.

14. Vorrichtung nach einem der Ansprüchen 1 bis 13,
**dadurch gekennzeichnet,**
**dass** die Lüfter (13) als EC-Ventilatoren ausgebildet sind.

15. Vorrichtung nach einem der Ansprüchen 1 bis 14,
**dadurch gekennzeichnet,**
**dass** der Kaltgang (40) gegenüber der Umgebung abgeschottet ist.

## Geänderte Patentansprüche

### Geänderte Patentansprüche gemäss Regel 137(2) EPÜ.

**1.** Klimasystem für eine Datenverarbeitungsanlage (1), die mindestens eine Reihe von Server-Schaltschränken (20) aufweist, wobei die Reihe von Server-Schaltschränken (20) einen Kaltgang (40) begrenzt, wobei von wenigstens einem Klimagerät (10) Warmluft angesaugt, gekühlt und als Kaltluft wieder ausgeblasen wird,
wobei das Klimagerät (10) in die Reihe der Server-Schaltschränke (20) integriert ist, wobei die Abmessungen des Klimagerätes (10) und die Abmessungen der Server-Schaltschränke (20) im Wesentlichen gleich sind oder, bei gleicher Höhe und Tiefe, die Breite des Klimagerätes (10) einem ganzzahligen Vielfachen der Breite eines Server-Schaltschranks (20) entspricht,
wobei das Klimagerät (10) aus mindestens einem Grundmodul (G) und einem oder weiteren vom Grundmodul (G) aus gesteuerten und mit Kühlwasser versorgten Erweiterungsmodulen (E) aufgebaut ist, wobei die Anzahl der Erweiterungsmodule (E) abhängig von der benötigten Kühlleistung für die Datenverarbeitungsanlage (1) angepasst ist.
